# FASCICULE DE BREVET EUROPEEN

(11) **EP 1 801 544 B1**
(45) Date de publication et mention de la délivrance du brevet: **04.03.2009**
(21) Numéro de dépôt: 06126547.6
(22) Date de dépôt: 19.12.2006
(51) Int. Cl.: G01D 5/14, G01D 5/245

(54) **Capteur magnétique de position à détéction optimisée**
Magnetischer Positionssensor mit optimierter Erkennung
Magnetic position sensor with optimised detection

(30) Priorité: 20.12.2005 FR 0512927
(43) Date de publication de la demande: 27.06.2007
(73) Titulaire: Electricfil Automotive, 01708 Miribel Cedex (FR)
(72) Inventeur: Legrand, Bertrand, 38000 Grenoble (FR)
(74) Mandataire: Thibault, Jean-Marc

(56) Documents cités:
- FR-A1- 2 757 943
- FR-A1- 2 827 955
- FR-A1- 2 856 144

## Description

La présente invention concerne le domaine technique des capteurs magnétiques comportant un élément codeur se déplaçant à proximité d'au moins une cellule de détection et adaptés pour repérer au moins une position angulaire au sens général.

L'objet de l'invention concerne, plus particulièrement, la réalisation d'un capteur dont le codeur est équipé d'une série de pôles nord et de pôles sud montés de manière alternée.

L'objet de l'invention trouve une application particulièrement avantageuse dans le domaine automobile, où ce capteur peut être utilisé, par exemple, dans le cadre des fonctions d'allumage.

Il est connu, dans le domaine préféré ci-dessus, de mettre en oeuvre un capteur magnétique adapté pour mesurer le changement d'intensité d'un champ magnétique, lorsqu'un codeur magnétique défile devant une cellule de détection. Un tel codeur est constitué par un anneau magnétique multipolaire pourvu, sur sa circonférence, de pôles nord et de pôles sud alternés et régulièrement espacés selon un pas donné. Les pôles réguliers nord et sud sont réalisés en nombre élevé, afin qu'un tel capteur de vitesse possède une bonne résolution.

La cellule de détection, telle qu'une sonde à effet Hall, par exemple, délivre un signal sinusoïdal périodique. La cellule de détection est associée à un comparateur de niveaux à hystérésis, tel qu'un trigger de Schmitt, permettant d'obtenir des transitions franches de la tension de sortie, pour des valeurs distinctes de l'induction magnétique, selon qu'elle varie en croissant ou en décroissant.

Pour permettre de déterminer au moins une position correspondant, par exemple, au point mort haut d'allumage d'un cylindre, il peut être envisagé, soit de supprimer plusieurs pôles magnétiques en laissant subsister un espace vide, soit de remplacer un ou plusieurs pôles d'un signe donné par un ou plusieurs pôles d'un signe contraire.

Il est ainsi réalisé un pôle, dit irrégulier, présentant, d'une part, une aimantation d'un signe opposé aux signes de ses deux pôles adjacents et, d'autre part, un écartement différent par rapport au pas d'écartement des autres pôles.

Afin d'obtenir une bonne précision de mesure, notamment en ce qui concerne la détection du pôle irrégulier, le brevet FR 2 757 943 enseigne de réaliser un codeur comprenant, pour chaque pôle irrégulier, des moyens de correction de la valeur du champ magnétique créé par le pôle irrégulier, de manière que le signal, délivré par le passage des pôles voisins auxdits pôles irréguliers, soit symétrique par rapport à la valeur nulle du champ magnétique.

La mise en oeuvre d'un tel codeur permet d'obtenir, en sortie de la cellule de détection du capteur, un signal magnétique dont la période est constante, pour ce qui concerne les pôles réguliers. Il en résulte une bonne précision des mesures ainsi réalisées, notamment pour le repérage du pôle irrégulier.

Il a été envisagé d'améliorer le codage de la position ou de la vitesse du codeur associé aux fonctions d'allumage d'un véhicule automobile. Pour atteindre cet objectif, il a été proposé d'utiliser le front intermédiaire du signal différentiel, situé entre les fronts issus du signal différentiel correspondant au passage des pôles adjacents aux pôles irréguliers.

Un objet de l'invention vise donc à proposer un capteur de position possédant une possibilité de codage augmentée par rapport aux capteurs de l'art antérieur, tout en présentant une bonne précision des mesures réalisées, notamment en relation du pôle irrégulier, avec une capacité de codage améliorée.

Pour atteindre un tel objectif, le capteur de position est du type comportant un codeur formé par un anneau magnétique multipolaire pourvu, sur sa circonférence, de pôles nord et de pôles sud alternés et montés pour défiler devant au moins une paire d'éléments de mesure délivrant chacun un signal périodique qui, d'une part, correspond à l'évolution de l'intensité du champ magnétique délivré par les pôles et, d'autre part, permet d'obtenir un signal différentiel entre les deux dits signaux, au moins l'un des pôles d'un signe contraire au signe de ses pôles adjacents est dit irrégulier et comporte, entre ses deux pôles adjacents, un écartement différent par rapport au pas d'écartement entre les autres pôles.

Selon l'invention, le pôle irrégulier comporte des moyens de correction de la valeur de son champ magnétique, de manière à stabiliser le signal différentiel, de sorte que la partie du signal différentiel prise au passage par zéro et située entre les parties du signal différentiel correspondant aux passages des pôles adjacents, comporte une pente dont la valeur, en valeur absolue, est sensiblement identique aux valeurs des pentes des parties du signal différentiel prises au passage par zéro et correspondant aux passages des autres pôles.

Selon une caractéristique de réalisation, les moyens de correction de la valeur du champ magnétique du pôle irrégulier sont adaptés pour stabiliser, de manière sensiblement identique, le front montant ou descendant issu du signal différentiel situé entre les fronts, respectivement descendants ou montants, issus du signal différentiel et correspondant au passage des pôles adjacents au pôle irrégulier.

Selon une autre caractéristique de réalisation, les moyens de correction de la valeur du champ magnétique du pôle irrégulier sont adaptés pour stabiliser, de manière sensiblement identique, le front montant ou descendant issu du signal différentiel situé entre les fronts, respectivement descendants ou montants, issus du signal différentiel et correspondant au passage de l'ensemble des pôles nord et sud.

Par exemple, les moyens de correction de la valeur du champ magnétique du pôle irrégulier sont tels que les pentes au passage par zéro, d'une part, de la partie du signal différentiel située entre les parties du signal différentiel correspondant aux passages des pôles adjacents et, d'autre part, des parties du signal différentiel correspondant aux passages des pôles adjacents et des autres pôles, possèdent une valeur sensiblement identique supérieure à 30 gauss par degré et, de préférence, supérieure à 100 gauss par degré.

Selon un exemple de réalisation, les moyens de correction de la valeur du champ magnétique du pôle irrégulier sont réalisés par une aimantation graduelle, telle que le signal brut obtenu, par le passage du pôle irrégulier devant un élément de mesure, varie de manière symétrique.

Avantageusement, le signal brut, obtenu par le passage du pôle irrégulier, comporte une partie croissante et une partie décroissance, séparées par une partie de liaison dont la largeur est au moins supérieure à la distance prise au niveau du rayon de mesure entre les éléments de mesure.

De préférence, la partie de liaison du signal brut présente une forme identique aux parties du signal brut correspondant aux pôles réguliers.

Selon une variante de réalisation, l'aimantation graduelle du pôle irrégulier présente un profil dont au moins une partie est un arc de courbe.

Selon une autre variante de réalisation, l'aimantation graduelle du pôle irrégulier présente un profil avec une partie en arc de courbe bordée, de part et d'autre, par une partie de décalage magnétique.

Selon une autre variante de réalisation, l'aimantation graduelle du pôle irrégulier présente un profil avec une partie en arc de courbe bordée, de part et d'autre, par des pôles de polarités opposées.

Selon une application préférée, le codeur est calé en rotation sur un arbre tournant d'un véhicule automobile.

Par exemple, le codeur est monté sur l'arbre d'un moteur d'un véhicule automobile.

Avantageusement, le codeur est monté sur un arbre de transmission d'un véhicule automobile.

Diverses autres caractéristiques ressortent de la description faite ci-dessous en référence aux dessins annexés qui montrent, à titre d'exemples non limitatifs, des formes de réalisations de l'objet de l'invention.

La **fig. 1** est une vue schématique en perspective montrant un exemple de réalisation d'un capteur de position conforme à l'invention.

La **fig. 2** est une vue, ramenée dans un plan, d'un exemple de réalisation d'un codeur conforme à l'invention.

Les **fig. 3A** et **3B** illustrent l'évolution de l'induction magnétique obtenue lors du défilement d'un codeur, respectivement dépourvu et équipé des moyens de correction conformes à l'invention.

Les **fig. 4A** et **4B** illustrent l'évolution du signal différentiel obtenu lors du défilement d'un codeur, respectivement dépourvu ou équipé des moyens de correction conformes à l'invention.

La **fig. 5** est un chronogramme obtenu lors du défilement d'un codeur, équipé ou non des moyens de correction conformes à l'invention.

Les **fig. 6** à **8** illustrent des exemples de réalisation de profils d'aimantation mettant en oeuvre les moyens de correction conformes à l'invention.

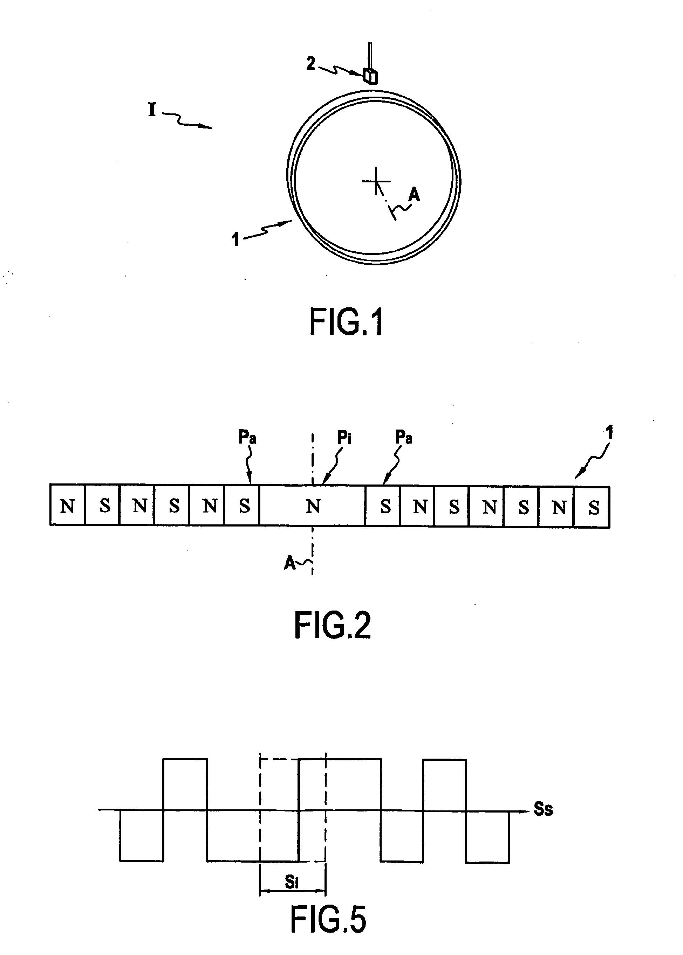

Les **fig. 1** et **2** montrent un exemple de réalisation d'un capteur magnétique de position **I** comportant un codeur magnétique **1** monté pour défiler devant au moins une paire d'éléments de mesure ou de détection **2,** pour constituer une cellule de détection. Le codeur **1** est constitué sous la forme d'un anneau magnétique multipolaire, entraîné en rotation autour de son centre, selon un axe **A** et pourvu, sur sa circonférence, de pôles nord **N** et de pôles sud **S** alternés, présentant une aimantation radiale. Par exemple, le codeur **1** est constitué par une couronne formant un support sur laquelle est adhérisée une bague, réalisée en élastomère, chargée de particules magnétisées pour constituer des pôles nord et sud.

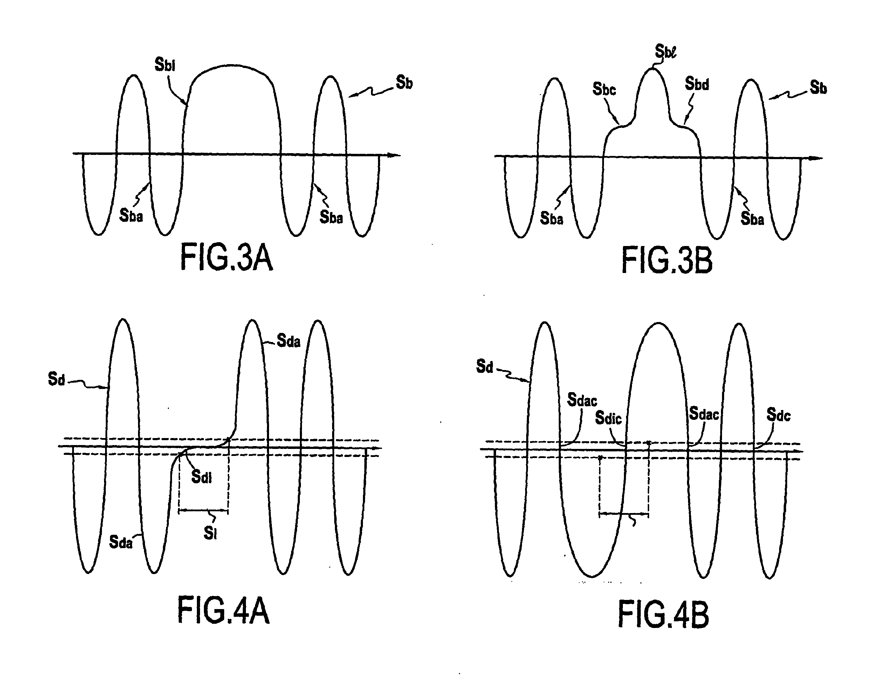

Chaque élément de mesure **2** délivre un signal périodique **Sb** (**fig. 3A, 3B**) correspondant à l'évolution de l'intensité du champ magnétique délivré par les pôles défilant devant elle. Par exemple, cette cellule de détection est une cellule à effet Hall, à effet Hall différentiel ou à effet Hall avec concentrateur de flux, voire même une cellule magnétorésistive ou une cellule magnétorésistante géante (GMR). Les éléments de détection 2 sont reliés à des moyens de traitement, non représentés mais connus en soi, permettant d'obtenir un signal différentiel **Sd**, obtenu en faisant la différence entre les signaux **Sb** délivrés par les éléments de détection **2 (**fig. 4A, 4B).

Dans l'exemple illustré, le codeur **1** comporte une série de pôles sud **S** et de pôles nord **N,** aménagés pour présenter un pas régulier d'écartement entre deux pôles voisins. Par exemple, la largeur angulaire de chaque pôle est de 3°. Tel que cela ressort plus précisément de la **fig. 2****,** le codeur **1** comporte aussi au moins un pôle irrégulier ou singulier **Pi** présentant, entre ses deux pôles adjacents **Pa,** un écartement différent par rapport au pas régulier d'écartement entre les pôles sud **S** et nord **N.** Dans l'exemple illustré, le pôle irrégulier **Pi** possède une largeur angulaire de 15° et constitue un pôle nord, tandis que les pôles adjacents **Pa** sont de signes contraires, à savoir sud. Bien entendu, les polarités des pôles adjacents **Pa** et du pôle irrégulier **Pi** peuvent être inversées.

En l'absence de l'objet de l'invention, chaque élément de mesure **2** délivre, tel que cela ressort plus précisément de la **fig. 3A****,** un signal brut, dit sans correction **Sb,** comportant des parties **Sba** et **Sbi** correspondant aux passages, respectivement, des pôles adjacents **Pa** et d'un pôle irrégulier **Pi.** Tel que cela ressort plus précisément de la **fig. 4A** et en l'absence de l'objet de l'invention, le signal différentiel, dit brut **Sd** entre les deux signaux délivrés par les éléments de mesure **2,** comporte des parties **Sda** et **Sdi** correspondant aux passages, respectivement, des pôles adjacents **Pa** et du pôle irrégulier **Pi.** Il est à noter que la partie du signal **Sdi,** située entre les parties **Sda,** présente une pente faible, qui entraîne une incertitude sur la position du front Si du signal de sortie **Ss** du capteur, tel qu'illustré à la **fig. 5****.**

Pour remédier à cet inconvénient et conformément à l'invention, chaque pôle irrégulier **Pi** comporte des moyens de correction **10** de la valeur de son champ magnétique, de manière à stabiliser le signal différentiel **Sd,** de sorte que la partie du signal différentiel **Sdic**, prise au passage par zéro, et située entre les parties **Sdac** du signal différentiel correspondant aux passages des pôles adjacents **Pa,** comporte une pente dont la valeur, en valeur absolue, est sensiblement identique aux valeurs des pentes des parties du signal différentiel prises au passage par zéro et correspondant au passage des autres pôles. Il doit être considéré que la pente de la partie **Sdic** du signal différentiel est sensiblement identique à la pente des parties **Sdac** du signal différentiel correspondant au passage des pôles adjacents et/ou à la pente des parties du signal différentiel correspondant au passage d'au moins certains et, de préférence, de l'ensemble des pôles réguliers. Selon une caractéristique avantageuse, la pente de la partie **Sdic** du signal différentiel est sensiblement identique à la pente des parties du signal différentiel correspondant au passage de l'ensemble des pôles **N** et **S,** dit régulier.

Dans l'exemple illustré à la **fig. 4B****,** la partie du signal différentiel, située entre les parties **Sdac** du signal différentiel correspondant au passage des pôles adjacents **Pa,** présente une partie montante **Sdic,** tandis que les parties **Sdac, Sdc** du signal différentiel correspondant au passage, respectivement, des pôles adjacents et des autres pôles, évoluent en descendant. La pente de cette partie montante **Sdic** du signal différentiel présente, au passage par le zéro gauss, une pente qui, en valeur absolue, est sensiblement identique aux valeurs des pentes des parties descendantes **Sdac** et/ou **Sdc** du signal différentiel, prises au passage par le zéro gauss.

Ces moyens de correction **10** de la valeur du champ magnétique du pôle irrégulier **Pi** sont tels que les pentes au passage par zéro, d'une part, de la partie **Sdic** du signal différentiel située entre les parties du signal différentiel correspondant au passage des pôles adjacents et, d'autre part, des parties **Sdac** et/ou **Sdc** du signal différentiel correspondant au passage des pôles adjacents et des autres pôles, possèdent une valeur sensiblement identique, par exemple supérieure à 30 gauss par degré et, de préférence, supérieure ou égale à 100 gauss par degré.

Tel que cela ressort de la description précédente, le front montant **Sdic** du signal différentiel, correspondant au passage du pôle irrégulier **Pi**, présente une stabilité du même ordre que les fronts descendants des autres pôles. Il peut être ainsi obtenu pour un codage dit 60 - 1 dent, 60 impulsions pour le signal de sortie correspondant à 59 fronts descendants et un front montant correspondant à la partie du signal différentiel intermédiaire située entre les deux pôles adjacents **Pa** au pôle irrégulier **Pi.**

De tels moyens de correction **10** permettent ainsi d'augmenter le codage, tout en conservant une bonne précision des mesures pour ce qui concerne le repérage du pôle irrégulier **Pi.**

Les moyens de correction **10** de la valeur du champ magnétique irrégulier sont réalisés par une aimantation graduelle du pôle régulier **Pi,** telle que le signal brut, obtenu par le passage du pôle irrégulier devant l'élément de mesure, varie de manière symétrique. Ainsi, tel que cela ressort plus précisément de la **fig. 3B****,** le signal obtenu **Sb** comporte une partie **Sbc** croissante et une partie décroissante **Sbd,** séparées par une partie de liaison **Sbl.**

Selon une caractéristique avantageuse de l'invention, cette partie de liaison **Sbl** comporte une largeur qui est au moins supérieure à la distance prise au niveau du rayon de mesure entre les deux éléments de mesure **2.**

Selon une autre caractéristique avantageuse de réalisation illustrée, la partie de liaison du signal brut **Sbl** présente, au décalage près, une forme identique aux parties du signal correspondant au pôle régulier, tel que cela ressort clairement de la **fig. 3B****.**

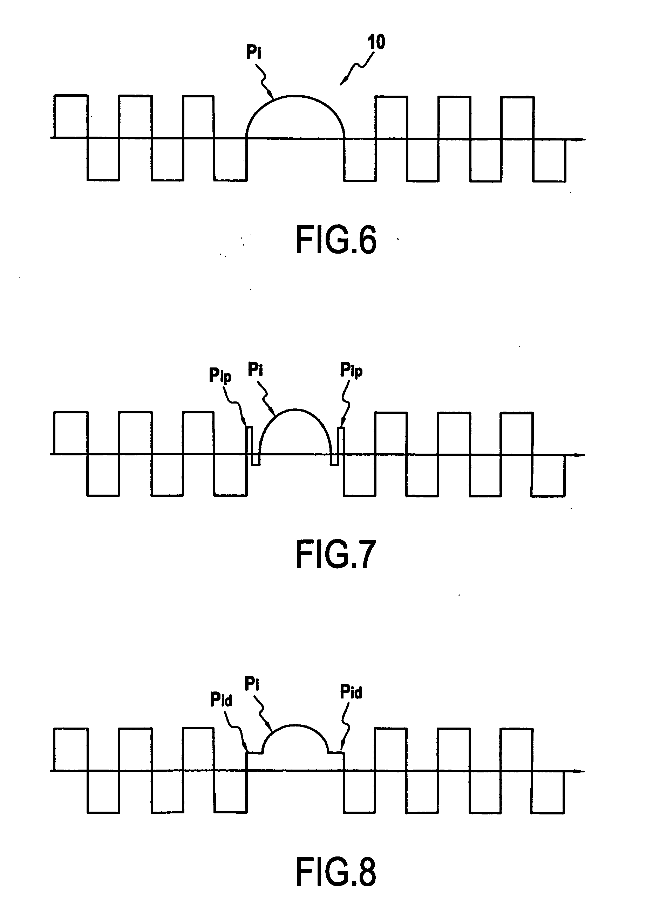

La **fig. 6** illustre un exemple de réalisation de l'aimantation graduelle du pôle irrégulier **Pi,** présentant un profil s'établissant selon un arc de courbe à caractère circulaire ou pseudo circulaire.

Tel qu'illustré à la **fig. 7**, l'aimantation graduelle du pôle irrégulier **Pi** présente un profil avec une partie en arc de courbe bordée, de part et d'autre, par une partie de décalage constituée par des pôles de polarités opposées **Pip.**

Dans l'exemple illustré à la **fig. 8**, l'aimantation graduelle du pôle irrégulier **Pi** présente un profil avec une partie en arc de courbe, bordée de part et d'autre par une partie de décalage magnétique **Pid.**

## Revendications

1. Capteur de position, du type comportant un codeur **(1)** formé par un anneau magnétique multipolaire pourvu, sur sa circonférence, de pôles nord **(N)** et de pôles sud **(S)** alternés et montés pour défiler devant au moins une paire d'éléments de mesure **(2)** délivrant chacun un signal périodique qui, d'une part, correspond à l'évolution de intensité du champ magnétique délivré par les pôles et, d'autre part, permet d'obtenir un signal différentiel entre les deux dits signaux, au moins l'un des pôles d'un signe contraire au signe de ses pôles adjacents est dit irrégulier **(Pi)** et comporte, entre ses deux pôles adjacents **(Pa),** un écartement différent par rapport au pas d'écartement entre les autres pôles,
**caractérisé en ce que** le pôle irrégulier **(Pi)** comporte des moyens **(10)** de correction de la valeur de son champ magnétique, de manière à stabiliser le signal différentiel, de sorte que la partie **(Sdic)** du signal différentiel prise au passage par zéro et située entre les parties **(Sdac)** du signal différentiel correspondant aux passages des pôles adjacents **(Pa),** comporte une pente dont la valeur, en valeur absolue, est sensiblement identique aux valeurs des pentes des parties du signal différentiel prises au passage par zéro et correspondant aux passages des autres pôles.

2. Capteur de position selon la revendication 1, **caractérisé en ce que** les moyens de correction **(10)** de la valeur du champ magnétique du pôle irrégulier sont adaptés pour stabiliser, de manière sensiblement identique, le front montant ou descendant issu du signal différentiel situé entre les fronts, respectivement descendants ou montants, issus du signal différentiel et correspondant au passage des pôles adjacents au pôle irrégulier.

3. Capteur de position selon la revendication 1, **caractérisé en ce que** les moyens de correction **(10)** de la valeur du champ magnétique du pôle irrégulier sont adaptés pour stabiliser, de manière sensiblement identique, le front montant ou descendant issu du signal différentiel situé entre les fronts, respectivement descendants ou montants, issus du signal différentiel et correspondant au passage de l'ensemble des pôles nord **(N)** et sud **(S).**

4. Capteur de position selon la revendication 1, **caractérisé en ce que** les moyens de correction **(10)** de la valeur du champ magnétique du pôle irrégulier **(Pi)** sont tels que les pentes au passage par zéro, d'une part, de la partie du signal différentiel située entre les parties du signal différentiel correspondant aux passages des pôles adjacents et, d'autre part, des parties du signal différentiel correspondant aux passages des pôles adjacents et des autres pôles, possèdent une valeur sensiblement identique supérieure à 30 gauss par degré et, de préférence, supérieure à 100 gauss par degré.

5. Capteur de position selon l'une des revendications 1 à 4, **caractérisé en ce que** les moyens de correction **(10)** de la valeur du champ magnétique du pôle irrégulier **(Pi)** sont réalisés par une aimantation graduelle, telle que le signal brut obtenu, par le passage du pôle irrégulier devant un élément de mesure, varie de manière symétrique.

6. Capteur de position selon la revendication 5, **caractérisé en ce que** le signal brut **(Sb),** obtenu par le passage du pôle irrégulier **(Pi),** comporte une partie croissante **(Sbc)** et une partie décroissante **(Sbd),** séparées par une partie de liaison **(Sbl)** dont la largeur est au moins supérieure à la distance prise au niveau du rayon de mesure entre les éléments de mesure **(2).**

7. Capteur de position selon la revendication 6, **caractérisé en ce que** la partie de liaison **(Sbl)** du signal brut présente une forme identique aux parties du signal brut correspondant aux pôles réguliers.

8. Capteur de position selon la revendication 7, **caractérisé en ce que** l'aimantation graduelle du pôle irrégulier **(Pi)** présente un profil dont au moins une partie est un arc de courbe.

9. Capteur de position selon la revendication 8, **caractérisé en ce que** l'aimantation graduelle du pôle irrégulier **(Pi)** présente un profil avec une partie en arc de courbe bordée, de part et d'autre, par une partie de décalage magnétique **(Pid).**

10. Capteur de position selon la revendication 8, **caractérisé en ce que** l'aimantation graduelle du pôle irrégulier **(Pi)** présente un profil avec une partie en arc de courbe bordée, de part et d'autre, par des pôles de polarités opposées **(Pip).**

11. Capteur de position selon l'une des revendications 1 à 10, **caractérisé en ce que** le codeur **(1)** est calé en rotation sur un arbre tournant d'un véhicule automobile.

12. Capteur de position selon la revendication 11, **caractérisé en ce que** le codeur **(1)** est monté sur l'arbre d'un moteur d'un véhicule automobile.

13. Capteur de position selon la revendication 11, **caractérisé en ce que** le codeur **(1)** est monté sur un arbre de transmission d'un véhicule automobile.

## Claims

1. A position sensor, of the type including an encoder (1) formed by a multi-polar magnetic ring provided on its circumference with alternating North poles (N) and South poles (S) mounted in order to pass in front of at least one pair of measuring components (2) each delivering a periodic signal which corresponds to the change in the intensity of the magnetic field delivered by the poles on the one hand and with which a differential signal between said both signals may be obtained on the other hand, at least one of the poles with a sign opposite to the sign of the adjacent poles is said to be irregular (Pi) and includes, between both of its adjacent poles (Pa), a gap different from the gap pitch between the other poles,
**characterized in that** the irregular pole (Pi) includes means (10) for correcting the value of its magnetic field, so as to stabilize the differential signal, so that the portion (Sdic) of the differential signal taken when passing through zero and located between the portions (Sdac) of the differential signal corresponding to the passages of the adjacent poles (Pa), includes a slope, the value of which in absolute value is substantially identical with the values of the slopes of the portions of the differential signal taken when passing through zero and corresponding to the passages of the other poles.

2. The position sensor according to claim 1, **characterized in that** the means for correcting (10) the value of the magnetic field of the irregular pole are adapted so as to stabilize in a substantially identical way the rising or falling front stemming from the differential signal located between the respectively falling or rising fronts, stemming from the differential signal and corresponding to the passage of the poles adjacent to the irregular pole.

3. The position sensor according to claim 1, **characterized in that** the means for correcting (10) the value of the magnetic field of the irregular pole are adapted so as to stabilize in a substantially identical way the rising or falling front stemming from the differential signal located between the respectively falling or rising fronts, stemming from the differential signal and corresponding to the passage of the whole of the North poles (N) and South poles (S).

4. The position sensor according to claim 1, **characterized in that** the means for correcting (10) the value of the magnetic field of the irregular pole (Pi) are such that the slopes upon passing through zero of the portion of the differential signal located between the portions of the differential signal corresponding to the passages of the adjacent poles on the one hand and, portions of the differential signal corresponding to the passages of the adjacent poles and of the other poles on the other hand, have a substantially identical value larger than 30 Gauss per degree and preferably larger than 100 Gauss per degree.

5. The position sensor according to any of claims 1 to 4, **characterized in that** the means for correcting (10) the value of the magnetic field of the irregular pole (Pi) are produced by gradual magnetization such that the raw signal obtained by the passing of the irregular pole in front of a measuring component, varies in a symmetrical way.

6. The position sensor according to claim 5, **characterized in that** the raw signal (Sb) obtained by the passage of the irregular pole (Pi), includes an increasing portion (Sbc) and a decreasing portion (Sbd) separated by a connecting portion (Sbl), the width of which is at least larger than the distance taken at the measurement radius, between the measuring components (2).

7. The position sensor according to claim 6, **characterized in that** the connecting portion (Sbl) of the raw signal has a shape identical to the portions of the raw signal corresponding to the regular poles.

8. The position sensor according to claim 7, **characterized in that** the gradual magnetization of the irregular pole (Pi) has a profile, at least one portion of which is a curve arc.

9. The position sensor according to claim 8, **characterized in that** the gradual magnetization of the irregular pole (Pi) has a profile with a curve arc portion bordered on either side by a magnetic shift portion (Pid).

10. The position sensor according to claim 8, **characterized in that** the gradual magnetization of the irregular pole (Pi) has a profile with a curve arc portion bordered on either side by poles of opposite polarities (Pip).

11. The position sensor according to any of claims 1 to 10, **characterized in that** the encoder (1) is blocked in rotation on a rotating shaft of a motor vehicle.

12. The position sensor according to claim 11, **characterized in that** the encoder (1) is mounted on the shaft of a motor of a motor vehicle.

13. The position sensor according to claim 11, **characterized in that** the encoder (1) is mounted on a transmission shaft of a motor vehicle.

## Patentansprüche

1. Positionssensor des Typs, der einen Codierer (1) umfaßt, der durch einen Multipol-Magnetring gebildet ist, der auf seinem Umfang mit Nordpolen (N) und Südpolen (S) versehen ist, die sich abwechseln und befestigt sind, um vor mindestens einem Paar von Meßelementen (2) vorbeizulaufen, die jeweils ein periodisches Signal liefern, das einerseits der Entwicklung der Stärke des durch die Pole gelieferten Magnetfeldes entspricht und andererseits das Erhalten eines Differentialsignals zwischen den zwei Signalen ermöglicht, wobei mindestens einer der Pole mit einem zum Vorzeichen seiner benachbarten Pole entgegengesetzten Vorzeichen unregelmäßig (Pi) genannt wird und zwischen seinen zwei benachbarten Polen (Pa) einen Abstand aufweist, der sich in bezug auf den Beabstandungsschritt zwischen den anderen Polen unterscheidet,
**dadurch gekennzeichnet, daß** der unregelmäßige Pol (Pi) Mittel (10) zur Korrektur des Werts seines Magnetfelds umfaßt, um das Differentialsignal zu stabilisieren, derart, daß der Abschnitt (Sdic) des Differentialsignals, der beim Nulldurchgang aufgenommen wird und sich zwischen den Abschnitten (Sdac) des Differentialsignals befindet, die den Durchgängen der benachbarten Pole (Pa) entsprechen, eine Flankensteilheit umfaßt, deren Absolutwert im wesentlichen identisch mit den Werten der Flankensteilheiten der Abschnitte des Differentialsignals ist, die beim Nulldurchgang aufgenommen werden und den Durchgängen der anderen Pole entsprechen.

2. Positionssensor nach Anspruch 1, **dadurch gekennzeichnet, daß** die Mittel zur Korrektur (10) des Werts des Magnetfelds des unregelmäßigen Pols angepaßt sind, um die aus dem Differentialsignal hervorgehende steigende oder fallende Flanke, die sich zwischen den fallenden beziehungsweise steigenden Flanken befindet, die aus dem Differentialsignal hervorgehen und dem Durchgang der dem unregelmäßigen Pol benachbarten Pole entsprechen, auf im wesentlichen identische Weise zu stabilisieren.

3. Positionssensor nach Anspruch 1, **dadurch gekennzeichnet, daß** die Mittel zur Korrektur (10) des Werts des Magnetfelds des unregelmäßigen Pols angepaßt sind, um die aus dem Differentialsignal hervorgehende steigende oder fallende Flanke, die sich zwischen den fallenden beziehungsweise steigenden Flanken befindet, die aus dem Differentialsignal hervorgehen und dem Durchgang der Gesamtheit der Nord- (N) und Südpole (S) entsprechen, auf im wesentlichen identische Weise zu stabilisieren.

4. Positionssensor nach Anspruch 1, **dadurch gekennzeichnet, daß** die Mittel zur Korrektur (10) des Werts des Magnetfelds des unregelmäßigen Pols (Pi) derart sind, daß die Flanken beim Nulldurchgang einerseits des Abschnitts des Differentialsignals, der sich zwischen den Abschnitten des Differentialsignals befindet, die den Durchgängen der benachbarten Pole entsprechen, und andererseits der Abschnitte des Differentialsignals, die den Durchgängen der benachbarten Pole und der anderen Pole entsprechen, einen im wesentlichen identischen Wert von über 30 Gauß pro Grad und vorzugsweise über 100 Gauß pro Grad besitzen.

5. Positionssensor nach einem der Ansprüche 1 bis 4, **dadurch gekennzeichnet, daß** die Mittel zur Korrektur (10) des Werts des Magnetfelds des unregelmäßigen Pols (Pi) durch eine graduelle Magnetisierung ausgeführt sind, derart, daß das Rohsignal, das durch den Durchgang des unregelmäßigen Pols vor einem Meßelement erhalten wird, symmetrisch variiert.

6. Positionssensor nach Anspruch 5, **dadurch gekennzeichnet, daß** das Rohsignal (Sb), das durch den Durchgang des unregelmäßigen Pols (Pi) erhalten wird, einen zunehmenden Abschnitt (Sbc) und einen abnehmenden Abschnitt (Sbd) umfaßt, die durch einen Verbindungsabschnitt (Sbl) getrennt sind, dessen Breite mindestens größer als die auf Höhe des Meßradius zwischen den Meßelementen (2) gemessene Entfernung ist.

7. Positionssensor nach Anspruch 6, **dadurch gekennzeichnet, daß** der Verbindungsabschnitt (Sbl) des Rohsignals eine Form aufweist, die identisch mit den Abschnitten des Rohsignals ist, die den regelmäßigen Polen entsprechen.

8. Positionssensor nach Anspruch 7, **dadurch gekennzeichnet, daß** die graduelle Magnetisierung des unregelmäßigen Pols (Pi) ein Profil aufweist, von dem mindestens ein Abschnitt ein Kurvenbogen ist.

9. Positionssensor nach Anspruch 8, **dadurch gekennzeichnet, daß** die graduelle Magnetisierung des unregelmäßigen Pols (Pi) ein Profil mit einem kurvenbogenförmigen Abschnitt aufweist, der auf beiden Seiten von einem Magnetverschiebungsabschnitt (Pid) eingefaßt ist.

10. Positionssensor nach Anspruch 8, **dadurch gekennzeichnet, daß** die graduelle Magnetisierung des unregelmäßigen Pols (Pi) ein Profil mit einem kurvenbogenförmigen Abschnitt aufweist, der auf beiden Seiten von Polen mit entgegengesetzten Polaritäten (Pip) eingefaßt ist.

11. Positionssensor nach einem der Ansprüche 1 bis 10, **dadurch gekennzeichnet, daß** der Codierer (1) rotierend auf einer Drehwelle eines Kraftfahrzeugs verkeilt ist.

12. Positionssensor nach Anspruch 11, **dadurch gekennzeichnet, daß** der Codierer (1) auf der Welle eines Kraftfahrzeugmotors befestigt ist.

13. Positionssensor nach Anspruch 11, **dadurch gekennzeichnet, daß** der Codierer (1) auf einer Antriebswelle eines Kraftfahrzeugs befestigt ist.
